# EUROPEAN PATENT APPLICATION

(11) **EP 4 125 308 A1**
(43) Date of publication of application: **01.02.2023**
(21) Application number: 21197034.8
(22) Date of filing: 16.09.2021
(51) Int. Cl.: H05K 1/02

(54) **FLEXIBLE CIRCUIT MEMBER, PREPARATION METHOD THEREOF AND BATTERY APPARATUS**

(30) Priority: 28.07.2021 CN 202110859242
(71) Applicant: CALB Co., Ltd., Changzhou City, Jiangsu Province (CN)
(72) Inventor: PAN, Fangfang, Changzhou City (CN); ZHI, Benfeng, Changzhou City (CN); WANG, Yawei, Changzhou City (CN); LI, Hongtai, Changzhou City (CN)
(74) Representative: Becker, Eberhard

(57) **Abstract**

A flexible circuit member (1) includes an extension unit having a first body portion (11), a second body portion (12), and a stacking portion (13) connected between the first and second body portions (11, 12). The stacking portion (13) has at least two layers due to the folding processing. A first end of the extension unit in a long-axis direction (X) is an end portion of the first body portion (11) that is not connected to the stacking portion (13). A second end of the extension unit in the long-axis direction (X) is an end portion of the second body portion (12) that is not connected to the stacking portion (13). A conductive wire harness for electrical signal transmission extends from the first end to the second end. After the stacking portion (13) is unfolded, a distance between the first and second ends in the long-axis direction (X) decreases.

## Description

### BACKGROUND

### Technical Field

The disclosure relates to the field of batteries, and in particular, relates to a flexible circuit member, a preparation method thereof, and a battery apparatus.

### Description of Related Art

In a power battery system, the voltage and temperature of the batteries are required to be monitored. Generally, flexible printed circuit (FPC) is used to collect information such as battery voltage and temperature status. With the upgrading and development of the power battery systems, the information collection technology used for collecting information on longer battery units among multi-row battery units and a battery pack with longer module size or without module has gradually developed. Therefore, a longer information collection component is required to monitor the working status of the battery. However, due to limitation of the processing technology, the manufacturing of longer flexible circuit boards is difficult, and the cost of production equipment is correspondingly high. Therefore, at present, for multi-row battery units or longer battery units, only multiple FPCs can be used for signal collection.

### SUMMARY

The disclosure provides a flexible circuit member, a preparation method thereof, and a battery apparatus.

In a first aspect, the disclosure provides a flexible circuit member, and the flexible circuit member is configured to collect information of a battery unit in a battery apparatus. The flexible circuit member is formed by performing folding processing on an integrally-formed flexible circuit board and includes an extension unit. The extension unit includes a first body portion, a second body portion, and a stacking portion connected between the first body portion and the second body portion. The stacking portion has at least two layers due to the folding processing. A first end of the extension unit in a long-axis direction is an end portion of the first body portion that is not connected to the stacking portion in the long-axis direction. A second end of the extension unit in the long-axis direction is an end portion of the second body portion that is not connected to the stacking portion in the long-axis direction. A conductive wire harness in the extension unit for electrical signal transmission extends from the first end to the second end. After the stacking portion is unfolded, a distance between the first end and the second end in the long-axis direction decreases.

In a second aspect, the disclosure further provides a battery apparatus including a battery groups and the abovementioned flexible circuit member, and the flexible circuit member spans over the battery group.

In a third aspect, the disclosure further provides a preparation method of a flexible circuit member, and the flexible circuit member is configured to collect information of a battery unit in a battery apparatus. The preparation method includes the following steps. An integrally-formed flexible circuit board is provided, and the flexible circuit board includes an extensible unit. The extensible unit includes a first body portion, a second body portion, and a connection portion connected between the first body portion and the second body portion. Folding processing is performed on the extensible unit to form an extension unit. The connection portion forms a stacking portion having at least two layers due to the folding processing. The extension unit includes a first body portion, a second body portion, and a stacking portion connected between the first body portion and the second body portion. A first end of the extension unit in a long-axis direction is an end portion of the first body portion that is not connected to the stacking portion in the long-axis direction. A second end of the extension unit in the long-axis direction is an end portion of the second body portion that is not connected to the stacking portion in the long-axis direction. A conductive wire harness in the extension unit for electrical signal transmission extends from the first end to the second end. A distance between the first end and the second end of the extension unit in the long-axis direction increases due to the folding processing.

### BRIEF DESCRIPTION OF THE DRAWINGS

For a better understanding of the disclosure, reference may be made to exemplary embodiments shown in the following drawings. The components in the drawings are not necessarily to scale and related elements may be omitted, or in some instances proportions may have been exaggerated, so as to emphasize and clearly illustrate the features described herein. In addition, related elements or components can be variously arranged, as known in the art. Further, in the drawings, like reference numerals designate same or like parts throughout the several views.
FIG. 1 is a schematic diagram of a flexible circuit member according to an embodiment of the disclosure.
FIG. 2 is a schematic diagram of the flexible circuit member according to another embodiment of the disclosure.
FIG. 3 is a schematic diagram of the flexible circuit member after a stacking portion is unfolded according to an embodiment of the disclosure.
FIG. 4 is a schematic diagram of the flexible circuit member after the stacking portion is unfolded according to another embodiment of the disclosure.
FIG. 5 is a schematic diagram of the flexible circuit member after the stacking portion is unfolded according to another embodiment of the disclosure.
FIG. 6 is a schematic diagram of the flexible circuit member according to another embodiment of the disclosure.
FIG. 7 is a schematic diagram of the flexible circuit member according to another embodiment of the disclosure.
FIG. 8 is a schematic diagram of the flexible circuit member after the stacking portion is unfolded according to another embodiment of the disclosure.
FIG. 9 is a schematic diagram of the flexible circuit member after the stacking portion is unfolded according to another embodiment of the disclosure.
FIG. 10 is a schematic diagram of the flexible circuit member according to another embodiment of the disclosure.
FIG. 11 is a schematic diagram of the flexible circuit member at the stacking portion according to an embodiment of the disclosure.
FIG. 12 is a partial schematic diagram of a battery apparatus according to an embodiment of the disclosure.
FIG. 13 is a flow diagram of a preparation method of a flexible circuit member according to an embodiment of the disclosure.

### DESCRIPTION OF THE EMBODIMENTS

The technical solutions in the exemplary embodiments of the disclosure will be described clearly and explicitly in conjunction with the drawings in the exemplary embodiments of the disclosure. The description proposed herein is just the exemplary embodiments for the purpose of illustrations only, not intended to limit the scope of the disclosure, so it should be understood that and various modifications and variations could be made thereto without departing from the scope of the disclosure.

In the description of the present disclosure, unless otherwise specifically defined and limited, the terms "first", "second" and the like are only used for illustrative purposes and are not to be construed as expressing or implying a relative importance. The term "plurality" is two or more. The term "and/or" includes any and all combinations of one or more of the associated listed items.

In particular, a reference to "the" object or "a" and "an" object is intended to denote also one of a possible plurality of such objects. Unless otherwise defined or described, the terms "connect", "fix" should be broadly interpreted, for example, the term "connect" can be "fixedly connect", "detachably connect", "integrally connect", "electrically connect" or "signal connect". The term "connect" also can be "directly connect" or "indirectly connect via a medium". For the persons skilled in the art, the specific meanings of the abovementioned terms in the present disclosure can be understood according to the specific situation.

Further, in the description of the present disclosure, it should be understood that spatially relative terms, such as "above", "below" "inside", "outside" and the like, are described based on orientations illustrated in the figures, but are not intended to limit the exemplary embodiments of the present disclosure.

In the context, it should also be understood that when an element or features is provided "outside" or "inside" of another element(s), it can be directly provided "outside" or "inside" of the other element, or be indirectly provided "outside" or "inside" of the another element(s) by an intermediate element.

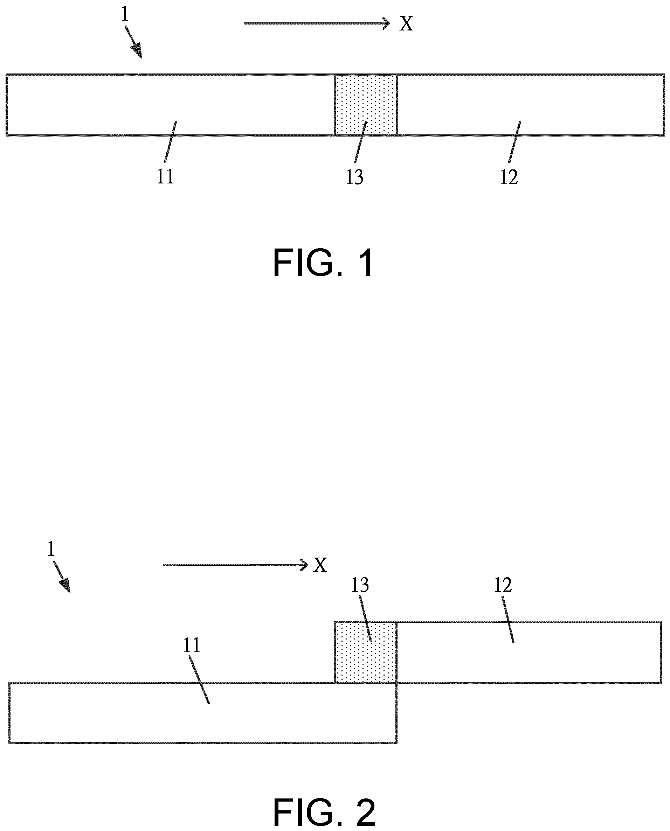

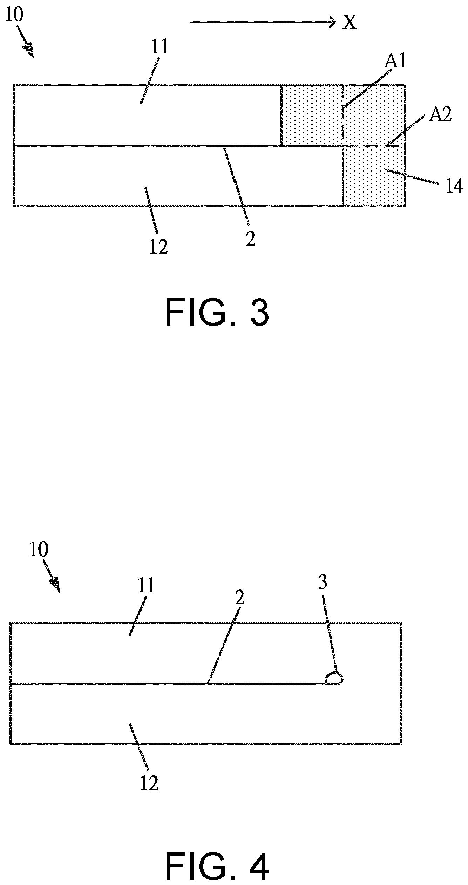

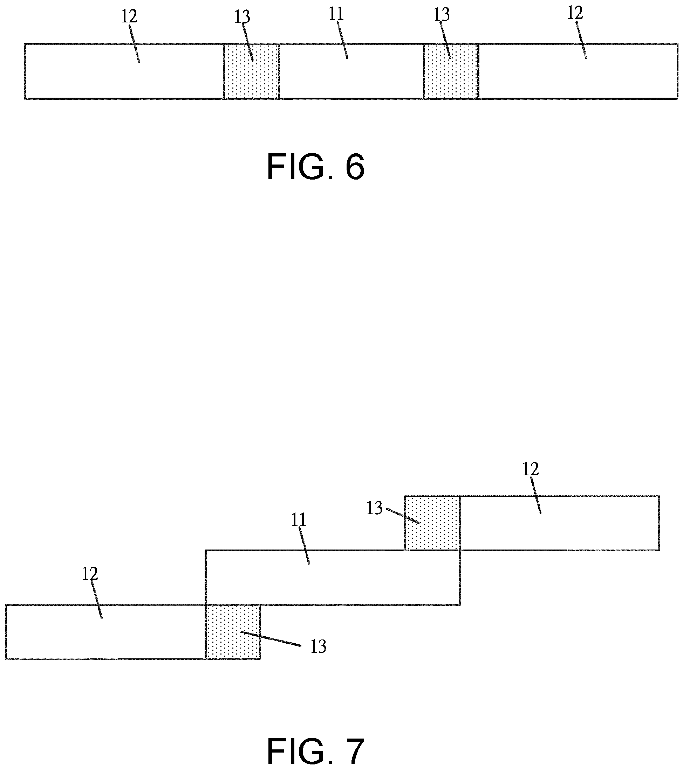

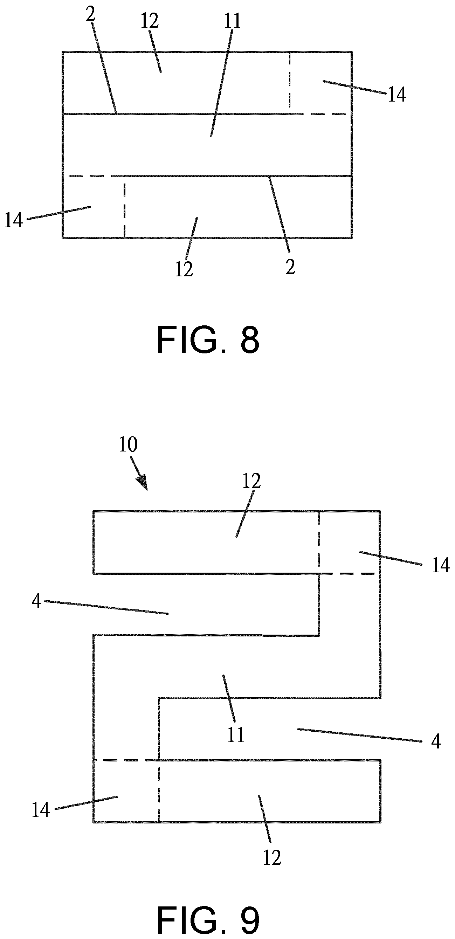

With reference to FIG. 1 to FIG. 9, wherein FIG. 1, FIG. 2, FIG. 6, and FIG. 7 are schematic diagrams of a flexible circuit member 1 provided by the embodiments of the disclosure. FIG. 3, FIG. 4, FIG. 5, FIG. 8, and FIG. 9 are schematic diagrams of a flexible circuit board 10 configured for folding to form the flexible circuit member 1 provided by the disclosure, or in other words, are schematic diagrams of the structure of the flexible circuit member 1 provided by the disclosure after a stacking portion 13 is unfolded. Further, FIG. 1 and FIG. 2 are schematic diagrams of the flexible circuit member 1 having one extension unit, and correspondingly, FIG. 3, FIG. 4, and FIG. 5 are schematic diagrams of the flexible circuit board 10 having one extensible unit. FIG. 6 and FIG. 7 are schematic diagrams of the flexible circuit member 1 having two extension units, and correspondingly, FIG. 8 and FIG. 9 are schematic diagrams of the flexible circuit board 10 having two extensible units.

In the first aspect, with reference to FIG. 1 to FIG. 5, the disclosure provides the flexible circuit member 1, and the flexible circuit member 1 is configured to collect information of a battery unit in a battery apparatus. The flexible circuit member 1 is formed by performing folding processing on the integrally-formed flexible circuit board 10 and includes an extension unit. The extension unit includes a first body portion 11, a second body portion 12, and a stacking portion 13 connected between the first body portion 11 and the second body portion 12. The stacking portion 13 has at least two layers due to the folding processing. A first end of the extension unit in a long-axis direction X is an end portion of the first body portion 11 that is not connected to the stacking portion 13 in the long-axis direction X. A second end of the extension unit in the long-axis direction X is an end portion of the second body portion 12 that is not connected to the stacking portion 13 in the long-axis direction X. A conductive wire harness in the extension unit for electrical signal transmission extends from the first end to the second end. In other words, in the long-axis direction X, the extension unit has two end portions, namely the first end and the second end. The two end portions individually are one end portion of the first body portion 11 and one end portion of the second body portion 12. The conductive wire harness extends from the first end to the second end and generally extends in the long-axis direction X of the extension unit. To be specific, after the stacking portion 13 is unfolded, a distance between the first end and the second end of the extension unit in the long-axis direction X decreases. In other words, after the stacking portion 13 is formed through folding processing, a distance between an end portion configured for forming a first end of the first body portion 11 and an end portion configured for forming a second end of the second body portion 12 in the long-axis direction X increases.

It is Noted that, in the disclosure, the extension unit refers to a structure which is generated after the stacking portion 13 is formed after the folding processing performed on the flexible circuit board 10, that is, the extension unit and the stacking portion 13 are both structures formed after folding. In the disclosure, a portion of the flexible circuit board 10 used for folding to form the extension unit is referred to as an "extensible unit", and a portion between the first body portion 11 and the second body portion 12 configured for folding to form the stacking portion 13 is referred to as a "connection portion 14". That is, the "extensible unit" and the "connection portion 14" are respectively structures corresponding to the "extension unit" and the "stacking portion 13" in an unfolded state. To be specific, the "unfolded state" may be a state before the flexible circuit board 10 is folded, or may be a state after the stacking portion 13 of the flexible circuit member 1 is unfolded. Besides, the "long-axis direction X" is a certain direction, and specifically, the long-axis direction is consistent with an extending direction of the extension unit and does not change due to the state of the flexible circuit board 10 before and after folding. Note that an X-axis direction in the drawings of the disclosure is only provided as an example. Specifically, the extending direction is at least one end of two ends on an X-axis straight line, and the extension unit extends in the X-axis direction as a whole.

In the disclosure, the flexible circuit member 1 is formed by folding the integrally-formed flexible circuit board 10, and the connection portion 14 between first body portion 11 and the second body portion 12 of the flexible circuit board 10 forms the stacking portion 13 through folding processing. After the folding processing is performed, a distance between one end of the first body portion 11 away from the stacking portion 13 and one end of the second body portion 12 away from the stacking portion 13 increases in the long-axis direction X. As such, a size of the flexible circuit member 1 in the long-axis direction X increases, and therefore, the flexible circuit member 1 may be used for information collection on a longer battery unit, for example, may be used for information collection requirements for batteries in multi-row battery units or in a battery pack with larger battery module size or without modules. In addition, in the flexible circuit member 1 provided by the embodiments of the disclosure, as the flexible circuit board 10 is folded, a length of the flexible circuit member 1 in the long-axis direction X increases, and the circuit member 1 is thus easily manufactured. Further, a size of the flexible circuit board 10 used for the folding process in the long-axis direction X is smaller and thus may be prepared by using the existing processing technique, so less manufacturing difficulty is required. For instance, the flexible circuit board 10 for folding processing may be obtained by directly cutting and forming a flexible circuit board having regular size.

Based on the above, in the embodiments of the disclosure, the flexible circuit member 1 has a longer length in the long-axis direction, and in this way, the information collection requirement on the battery unit having longer length in a power battery system may be satisfied. Further, the overall manufacturing difficulty of the flexible circuit member 1 is low, and the flexible circuit member 1 is easily manufactured.

Besides, compared to the solution of using a plurality of connectors and a plurality of flexible circuit boards to collect information on a battery unit having longer length, the longer flexible circuit member 1 provided by the embodiments of the disclosure is directly prepared by using the integrally-formed flexible circuit board 10, and in this way, less connectors are required to be used, production costs are lowered, and improved reliability is provided.

To be specific, at present, in an FPC production process, a processing length of an integrally-formed FPC is limited. A size and costs of production and processing equipment required for a longer FPC is large, so it is difficult to use conventional processing techniques to produce a longer FPC. In the embodiments of the disclosure, first, a conventional processing technique is used to manufacture the integrally-formed flexible circuit board 10 required for molding. The integrally-formed flexible circuit board 10 is then folded to form the flexible circuit member 1 that is longer in the long-axis direction X, so as to meet the length requirement for the flexible circuit member 1 in the power battery system. Further, in the flexible circuit member 1 provided by the embodiments of the disclosure, each extension unit is folded in the long-axis direction X to become longer. As such, by arranging a plurality of extension units in the flexible circuit member 1, a requirement for various lengths may be met in principle.

In some embodiments, as shown in FIG. 1 to FIG. 5, the first body portion 11 and the second body portion 12 are strip-shaped, and an extending direction of the first body portion 11 and an extending direction of the second body portion 12 are both parallel to the long-axis direction X. In this way, the distance between the end portion (i.e., the first end of the extension unit) of the first body portion 11 that is not connected to the stacking portion 13 and the end portion (i.e., the second end of the extension unit) of the second body portion 12 that is not connected to the stacking portion 13 increases as much as possible in the long-axis direction X As such, the length of the whole flexible circuit member 1 in the long-axis direction X increases.

Exemplarily, as shown in FIG. 3, FIG. 4, and FIG. 5, before the folding processing is performed, in the extensible unit of the flexible circuit board 10, the first body portion 11 and the second body portion 12 are arranged in parallel, and the extending directions of the first body portion 11 and the second body portion 12 are parallel to the long-axis direction X. After the folding processing is performed, the extensible unit becomes the extension unit. As shown in FIG. 1 and FIG. 2, in the extension unit, the first main body portion 11 and the second main body portion 12 extend sequentially in the long-axis direction X, such that the entire flexible circuit member 1 is extended in the long-axis direction X.

It is noted that, the first body portion 11 and the second body portion 12 are strip-shaped, and this means that the first body portion 11 and the second body portion 12 extend in one direction as a whole, or means that the size is larger in one direction, but specific shapes of the first body portion 11 and the second body portion 12 are not limited. For instance, in the extending directions, the first body portion 11 and the second body portion 12 may have partially curved sections or may be provided with some branches, but this does not affect overall strip-shaped extension of the first body portion 11 and the second body portion 12.

Exemplarily, as shown in FIG. 1, in the extension unit, the extending direction of the first body portion 11 and the extending direction of the second body portion 12 are parallel. To be specific, the extending direction of the first body portion 11 and the extending direction of the second body portion 12 are located on a straight line. Certainly, the extending direction of the first body portion 11 and the extending direction of the second body portion 12 may be staggered, that is, not on a straight line, as shown in FIG. 2, for example. To be specific, "the extending direction of the first body portion 11 and the extending direction of the second body portion 12 are located on a straight line" is relative to "the extending direction of the first body portion 11 and the extending direction of the second body portion 12 are staggered". These features do not limit the sizes and shapes of the first body portion 11 and the second body portion 12.

In some embodiments, as shown in FIG. 3 and FIG. 4, after the stacking portion 13 of the extension unit is unfolded, a cutting slit 2 is provided between the first body portion 11 and the second body portion 12. To be specific, an extending direction of the cutting slit 2 is parallel to the long-axis direction X. A first end of the cutting slit 2 is an open structure, that is, a cut, and a second end of the cutting slit 2 is adjacent to the unfolded stacking portion 13. In other words, in the flexible circuit board 10 configured for folding processing, only the cutting slit 2 is provided between the first body portion 11 and the second body portion 12 of the extensible unit. In actual practices, incomplete cutting is only required to be performed on a flexible circuit board material to form one cutting slit 2 with a side cut, and manufacturing and forming may be completed in this way.

To be specific, in this embodiment, taking the flexible circuit board 10 including one extensible unit as an example, a manufacturing process of the flexible circuit board 10 is provided as follows. A piece of square flexible circuit board material is provided, and half cutting is performed in a direction parallel to a longer side of the square flexible circuit board material to form one cutting slit 2. The first body portion 11 and the second body portion 12 are formed on two sides of the cutting slit 2. The first end of the cutting slit 2 is cut, which is an open cut, and the second end of the cutting slit 2 is not cut. The first body portion 11 and the second body portion 12 are connected by the uncut portion, which acts as the connection portion 14. To be specific, the connection portion 14 is subsequently used for folding processing to form the stacking portion 13. For instance, in the flexible circuit board 10 configured for folding processing shown in FIG. 3, the connection portion 14 is folded once along a folding line A1, and the final flexible circuit member 1 shown in FIG. 2 may be accordingly formed. Alternatively, the connection portion 14 is folded along the folding line A1 once and folded along a folding line A2 once, and the final flexible circuit member 1 as shown in FIG. 1 may be accordingly formed. Obviously, compared to the flexible circuit board 10 in the unfolded state, the distance between the two ends of the flexible circuit member 1 formed after folding in the long-axis direction X increases. That is, the entire flexible circuit member 1 is elongated in the long-axis direction X.

Exemplarily, as shown in FIG. 4, the second end of the cutting slit 2 is provided with an anti-tearing opening 3. Since the second end of the cutting slit 2 is not cut, the flexible circuit board 10 may be easily torn along the cutting slit 2. By arranging the opening 3 at the second end of the cutting slit 2, stress concentration is prevented from occurring at the second end of the cutting slit 2, and thereby, tearing is effectively prevented from occurring.

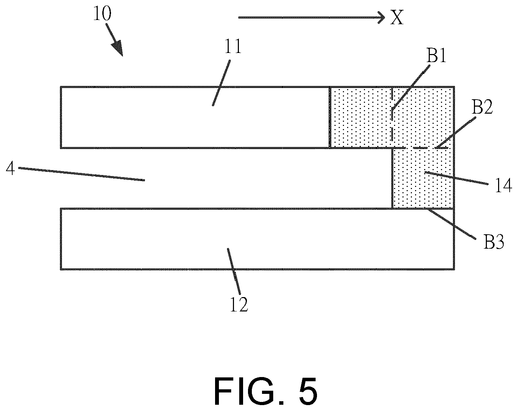

In some other embodiments, as shown in FIG. 5, after the stacking portion 13 of the extension unit is unfolded, a strip-shaped groove 4 is provided between the first body portion 11 and the second body portion 12. To be specific, an extending direction of the strip-shaped groove 4 is parallel to the long-axis direction X. A first end of the strip-shaped groove 4 is an open structure, that is, a notch, and a second end of the strip-shaped groove 4 is adjacent to the unfolded stacking portion 13. In other words, in the flexible circuit board 10 configured for folding processing, one strip-shaped groove 4 is provided between the first body portion 11 and the second body portion 12 of the extensible unit. In actual practices, by cutting a flexible circuit board material to form one strip-shaped groove 4, manufacturing and forming may be completed in this way.

To be specific, in the disclosure, the "strip-shaped groove 4" means that the groove extends in one direction or means that the size thereof is larger in one direction, but a specific shape of the groove is not limited. For instance, the "strip-shaped groove 4" may be a rectangular groove, a trapezoidal groove, or a wavy grove with undulating edges.

To be specific, in this embodiment, taking the flexible circuit board 10 including one extensible unit as an example, the manufacturing process of the flexible circuit board 10 is provided as follows. A piece of square flexible circuit board material is provided, and one strip-shaped groove 4 is formed through cutting. An extending direction of the strip-shaped groove 4 is parallel to a longer side of the flexible circuit board material. Two sides of the strip-shaped groove 4 forms on the first body portion 11 and the second body portion 12. The first end of the strip-shaped groove 4 is an open structure, that is, a notch. The second end of the strip-shaped groove 4 is adjacent to the connection portion 14. The first body portion 11 and the second body portion 12 are connected through the connection portion 14, and the entire flexible circuit board 10 is approximately in a "C" shape. To be specific, the connection portion 14 is subsequently used for folding processing to form the stacking portion 13. For instance, in the flexible circuit board 10 configured for folding processing as shown in FIG. 5, the connection portion 14 is folded along a folding line B1 once and folded along a folding line B2 once, and the flexible circuit member 1 as shown in FIG. 2 may be accordingly formed. Certainly, the connection portion 14 may also be folded along the folding line B1 once, folded along the folding line B2 once, and folded along a folding line B3 once to form the final flexible circuit member 1 as shown in FIG. 1. Obviously, compared to the flexible circuit board 10 in the unfolded state, the distance in the long-axis direction X between the two ends of the flexible circuit member 1 formed after folding is increased. That is, the entire flexible circuit member 1 is elongated in the long-axis direction X.

In some embodiments, as shown in FIG. 6 and FIG. 7, the flexible circuit member 1 provided by this embodiment includes at least two extension units. Any adjacent two extension units share one first body portion 11 or one second body portion 12. Two ends of the shared first body portion 11 or the shared second body portion 12 are connected to the stacking portions 13 of the adjacent two extension units in the long-axis direction X.

Correspondingly, as shown in FIG. 8, the flexible circuit board 10 configured for folding processing includes at least two extensible units. Each of the at least two extensible units has one connection portion 14 and one cutting slit 2. Directions of the cuts of two adjacent cutting slits 2 are opposite, and the board material between the two adjacent cutting slits 2 acts as the shared first body portion 11 or the shared second body portion 12.

Alternatively, as shown in FIG. 9, the flexible circuit board 10 configured for folding processing includes at least two extensible units. Each of the at least two extensible units has one connection portion 14 and one strip-shaped groove 4. Directions of the notches of two adjacent strip-shaped grooves 4 are opposite, the board material between the two adjacent strip-shaped grooves 4 acts as the shared first body portion 11 or the shared second body portion 12, and the two adjacent extensible units are approximately in a "S" shape.

For instance, as shown in FIG. 6 to FIG. 9, the flexible circuit member 1 provided by this embodiment includes two extension units, and the two extension units share the first body portion 11. Compared to the two extensible units in the unfolded state, sizes of the two extensible units in the long-axis direction X increase after folding. As such, the flexible circuit member 1 is elongated in the long-axis direction X and may thus be used for information collection on a longer battery unit.

It is noted that, in the disclosure, the shape of the flexible circuit board 10 configured for folding to form the flexible circuit member 1 is not limited to the shapes provided in the foregoing embodiments, and other shapes may be applicable according to actual applications, as long as the distance between the flexible circuit board 10 and the conductive wire harness thereof may be increased through folding processing in the long-axis direction X.

In some embodiments, a folding line is provided between adjacent layers in the stacking portion 13, and the stacking portion 13 at least has one folding line perpendicular to the long-axis direction X. In other words, the connection portion 14 of the extensible unit is folded at least once along the folding line perpendicular to the long-axis direction X to finally form the required stacking portion 13.

For instance, in the flexible circuit board 10 configured for folding processing as shown in FIG. 3, the connection portion 14 is folded along the folding line A1 and the folding line A2, and the stacking portion 13 shown in FIG. 1 may be accordingly formed. Therefore, the stacking portion 13 includes the folding line A1 and the folding line A2, and the folding line A1 is perpendicular to the long-axis direction X. In the flexible circuit board 10 configured for folding processing as shown in FIG. 5, the connection portion 14 is folded along the folding line B1 once and along the folding line B2 once, and the stacking portion 13 shown in FIG. 2 may be accordingly formed. Therefore, the stacking portion 13 includes the folding line B1 and the folding line B2, and the folding line B1 is perpendicular to the long-axis direction X.

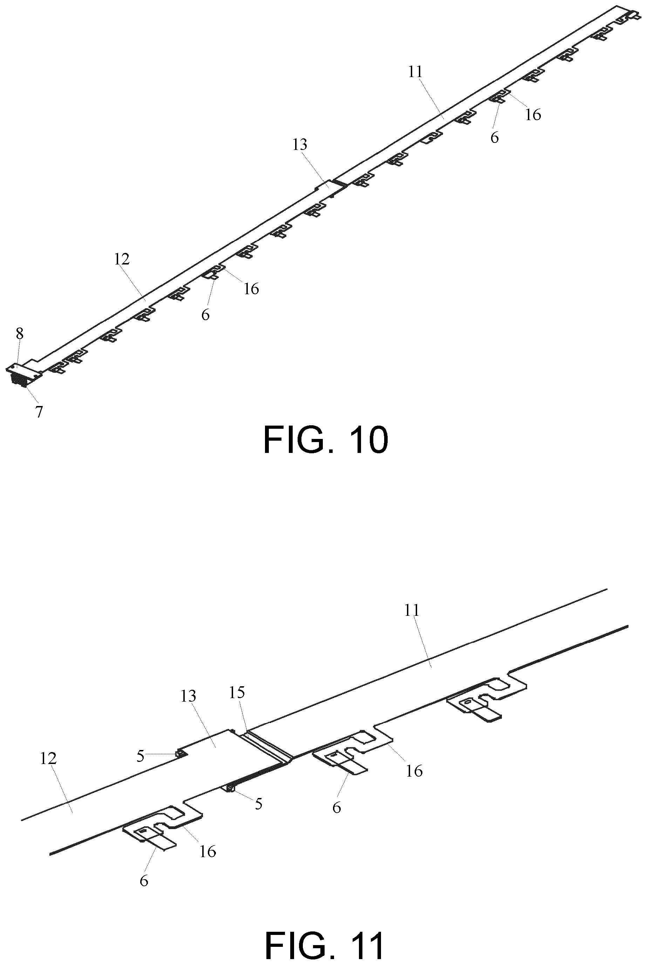

In some embodiments, as shown in FIG. 11, a buffer portion 15 extending in a curved shape is provided between the first body portion 11 and the stacking portion 13, and/or the buffer portion 15 extending in a curved shape is provided between the second body portion 12 and the stacking portion 13. To be specific, the buffer portion 15 extending in a curved shape is provided between the body portion and the stacking portion 13. On the one hand, the stacking portion 13 with a larger thickness may be bent downwards, such that the stacking portion 13 may be accommodated in a gap between adjacent battery groups. In this way, an internal space of the battery apparatus may be effectively used, and arrangement of other structures in the battery apparatus may be prevented from being affected. On the other hand, the buffer portion 15 may form a buffering effect and prevent the flexible circuit member 1 from being torn when being applied by a force.

In some embodiments, as shown in FIG. 11, the flexible circuit member 1 provided by the disclosure further includes a support structure 5 disposed between adjacent layers in the stacking portion 13. The support structure 5 may be used to increase strength of the stacking portion 13, and thus the strength of the entire flexible circuit member 1 is increased.

Further, adjacent layers of the stacking portion 13 may be bonded by an adhesive.

Exemplarily, the support structure 5 is a plate-shaped structure parallel to a layer structure of the stacking portion 13, and an area of the plate-shaped structure may approximately be identical to that of the layer structure of the stacking portion 13. To be specific, the plate-shaped structure and the adjacent layer structure of the stacking portion 13 are bonded through an adhesive.

Exemplarily, as shown in FIG. 11, the support structure 5 is a strip-shaped structure parallel to the layer structure of the stacking portion 13, and the strip-shaped structure is disposed in a folded bent zone of adjacent layers in the stacking portion 13. The "folded bent zone" is a portion that is bent due to folding. Further, other regions of the adjacent layers are bonded by an adhesive.

In some embodiments, as shown in FIG. 10 and FIG. 11, the first body portion 11 and/or the second body portion 12 is provided with a branch 16, and the branch 16 is configured to be connected to a collection sheet 6 to perform information collection on the battery unit. To be specific, the collection sheet 6 may be a metal nickel sheet.

In some embodiments, as shown in FIG. 10, the flexible circuit member 1 provided by the disclosure may further include structures such as a connector 7 and a protective plate 8. To be specific, the connector 7 and the protective plate 8 are disposed on one of the end portions of the flexible circuit member 1 in the long-axis direction X to act as an output end of the flexible circuit member 1.

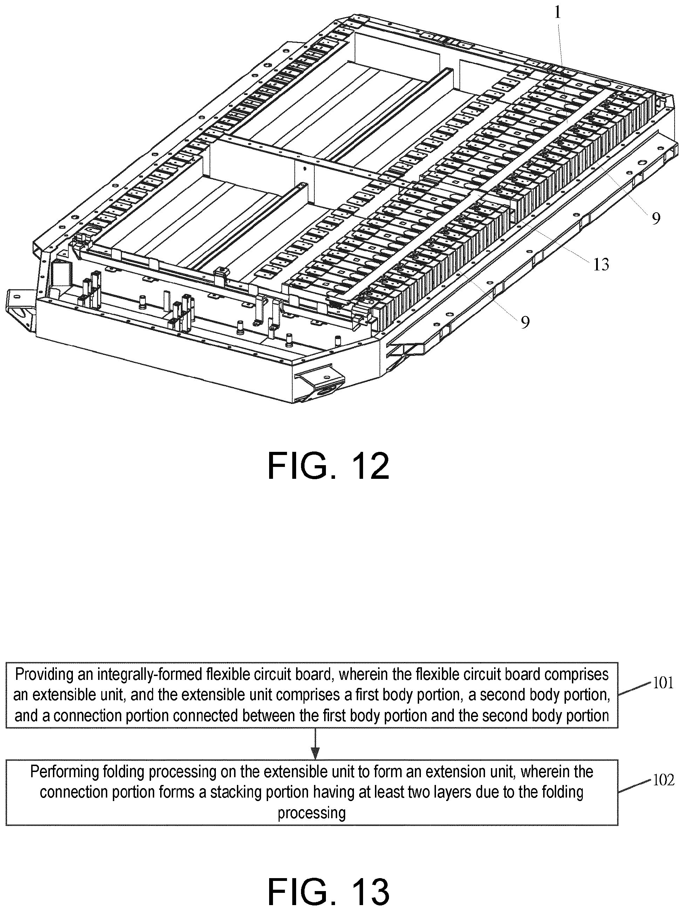

In the second aspect, the disclosure provides a battery apparatus, and as shown in FIG. 12, the battery apparatus includes a battery group 9 and the flexible circuit member 1 as described above. The battery group 9 includes at least two batteries. To be specific, the flexible circuit member 1 spans over the battery group 9 to collect information on each battery unit in the battery group 9.

In some embodiments, as shown in FIG. 12, the battery apparatus includes at least two battery groups 9, and the flexible circuit member 1 spans over the at least two battery groups 9. The stacking portion 13 of the flexible circuit member 1 is located in a gap between the adjacent battery groups 9. Since the stacking portion 13 has a larger thickness, arranging the stacking portion 13 in the gap between the adjacent battery groups 9 may effectively use the gap between the battery groups 9, to improve the space utilization rate and avoid affecting the arrangement of other structures in the battery apparatus.

In some embodiments, the battery apparatus may be a battery module. That is, in addition to the battery groups 9 and the flexible circuit member 1, the battery apparatus further includes structures such as an end plate, a side plate, and a cover plate for packaging the battery groups. Alternatively, as shown in FIG. 12, the battery apparatus may also be a battery pack, that is, the structures such as the end plate and the side plate are omitted, and the battery groups 9 and the flexible circuit member 1 are directly disposed in a box body of the battery pack.

In the third aspect, the disclosure further provides a preparation method of a flexible circuit member, and the flexible circuit member is configured to collect information of a battery unit in a battery apparatus. As shown in FIG. 13, the preparation method includes the following steps.

In step 101, an integrally-formed flexible circuit board 10 is provided. As shown in FIG. 3, FIG. 4, and FIG. 5, the flexible circuit board 10 includes an extensible unit. The extensible unit includes a first body portion 11, a second body portion 12, and a connection portion 14 connected between the first body portion 11 and the second body portion 12.

In step 102, folding processing is performed on the extensible unit to form an extension unit. The connection portion 14 forms a stacking portion 13 having at least two layers due to the folding processing. As shown in FIG. 1 and FIG. 2, the extension unit includes the first body portion 11, the second body portion 12, and the stacking portion 13 connected between the first body portion 11 and the second body portion 12. The first end of the extension unit in the long-axis direction X is the end portion of the first body portion 11 that is not connected to the stacking portion 13 in the long-axis direction X. The second end of the extension unit in the long-axis direction X is the end portion of the second body portion 12 that is not connected to the stacking portion 13 in the long-axis direction X. The conductive wire harness for electrical signal transmission in the extension unit extends from the first end to the second end. The distance between the first end and the second end of the extension unit in the long-axis direction X increases due to the folding processing.

In some embodiments, the step 101, providing the integrally-formed flexible circuit board, may include the following step. Cutting a piece of flexible circuit board material to obtain at least one integrally-formed flexible circuit board.

Exemplarily, the step of cutting the piece of flexible circuit board material may further include the following steps.

As shown in FIG. 3 and FIG. 4, a square flexible circuit board material is cut in a direction parallel to a longer side of the square flexible circuit board material to form a cutting slit 2. Two sides of the cutting slit 2 forms the first body portion 11 and the second body portion 12. A first end of the cutting slit 2 is a cut, and a second end of the cutting slit 2 is adjacent to the connection portion 14. To be specific, in this embodiment, the flexible circuit board 10 formed after cutting includes one extensible unit.

Further, the step 102, performing folding processing on the extensible unit to form the extension unit, may specifically include the following step: folding the connection portion 14 at least once along the folding line A1 perpendicular to the extending direction of the cutting slit 2 to form the stacking portion 13. For instance, in the flexible circuit board 10 configured for folding processing shown in FIG. 3, the connection portion 14 is folded once along the folding line A1, and the final flexible circuit member 1 shown in FIG. 2 may be accordingly formed. Alternatively, the connection portion 14 is folded along the folding line A1 once and folded along the folding line A2 once, and the final flexible circuit member 1 as shown in FIG. 1 may be accordingly formed.

Exemplarily, the step of cutting the piece of flexible circuit board material may specifically include the following steps.

As shown in FIG. 5, a strip-shaped groove 4 is cut on a square flexible circuit board material. An extending direction of the strip-shaped groove 4 is parallel to a longer side direction of the square flexible circuit board material. Two sides of the strip-shaped groove 4 form the first body portion 11 and the second body portion 12. A first end of the strip-shaped groove 4 is a notch and a second end of the strip-shaped groove 4 is adjacent to the connection portion 14. To be specific, in this embodiment, the flexible circuit board 10 formed after cutting includes one extensible unit.

Further, the step 102, performing folding processing on the extensible unit to form the extension unit, may specifically include the following step: folding the connection portion 14 at least once along the folding line A1 perpendicular to the extending direction of the strip-shaped groove 4 to form the stacking portion 13. For instance, in the flexible circuit board 10 configured for folding processing shown in FIG. 5, the connection portion 14 is folded along the folding line B1 once and is folded along the folding line B2 once, and the flexible circuit member 1 as shown in FIG. 2 may be accordingly formed. Alternatively, the connection portion 14 may also be folded along the folding line B1 once, folded along the folding line B2 once and folded along the folding line B3 once, to form the final flexible circuit member 1 as shown in FIG. 1.

Certainly, in the step of cutting the piece of flexible circuit board material to obtain the integrally-formed flexible circuit board, a plurality of (including two) cutting slits 2 or strip-shaped grooves 4 may be formed, such that the flexible circuit board 10 may form a plurality of extensible units. To be specific, directions of the cuts of two adjacent cutting slits 2 or directions of the notches of two adjacent strip-shaped grooves 4 are opposite, and specific illustration may be found with reference to FIG. 8 and FIG. 9.

To be specific, the preparation method of the flexible circuit member provided by the disclosure share the same embodiments and the same beneficial effects as the flexible circuit member provided by the disclosure, and description thereof is not repeated herein.

Other embodiments of the disclosure will be apparent to those skilled in the art from consideration of the specification and practice of the disclosure disclosed herein. The disclosure is intended to cover any variations, uses or adaptations of the disclosure. These variations, uses, or adaptations follow the general principles of the disclosure and include common general knowledge or conventional technical means in the art that are not disclosed in the present disclosure. The specification and embodiments are illustrative.

## Claims

1. A flexible circuit member (1), configured to collect information of a battery unit in a battery apparatus, the flexible circuit member (1) being formed by performing folding processing on an integrally-formed flexible circuit board (10), and the flexible circuit member (1) comprising an extension unit, wherein the extension unit includes a first body portion (11), a second body portion (12), and a stacking portion (13) connected between the first body portion (11) and the second body portion (12),
the stacking portion (13) has at least two layers due to the folding processing,
a first end of the extension unit in a long-axis direction (X) is an end portion of the first body portion (11) that is not connected to the stacking portion (13) in the long-axis direction (X), and a second end of the extension unit in the long-axis direction (X) is an end portion of the second body portion (12) that is not connected to the stacking portion (13) in the long-axis direction (X),
a conductive wire harness in the extension unit for electrical signal transmission extends from the first end to the second end,
a distance between the first end and the second end in the long-axis direction (X) decreases after the stacking portion (13) is unfolded.

2. The flexible circuit member (1) according to claim 1, wherein a cutting slit (2) is provided between the first body portion (11) and the second body portion (12) after the stacking portion (13) is unfolded, a first end of the cutting slit (2) is a cut, and a second end of the cutting slit (2) is adjacent to the unfolded stacking portion (13).

3. The flexible circuit member (1) according to claim 2, wherein the second end of the cutting slit (2) is provided with an anti-tearing opening (3).

4. The flexible circuit member (1) according to claim 1, wherein after the stacking portion (13) is unfolded, a strip-shaped groove (4) is provided between the first body portion (11) and the second body portion (12), and a first end of the strip-shaped groove (4) is a notch and a second end of the strip-shaped groove (4) is adjacent to the unfolded stacking portion (13).

5. The flexible circuit member (1) according to any one of claims 1-4, comprising at least two extension units, wherein any adjacent two extension units share one first body portion (11) or one second body portion (12), and two ends of the shared first body portion (11) or the shared second body portion (12) are respectively connected to the stacking portions of the adjacent two extension units in the long-axis direction (X).

6. The flexible circuit member (1) according to any one of claims 1-4, wherein a folding line is provided between adjacent layers in the stacking portion (13), and the stacking portion (13) at least has the folding line perpendicular to the long-axis direction (X).

7. The flexible circuit member (1) according to any one of claims 1-4, wherein the first body portion (11) and the second body portion (12) are strip-shaped, and an extending direction of the first body portion (11) and an extending direction of the second body portion (12) are parallel to the long-axis direction (X).

8. The flexible circuit member (1) according to claim 7, wherein the extending direction of the first body portion (11) and the extending direction of the second body portion (12) are located on a straight line.

9. The flexible circuit member (1) according to any one of claims 1-4, wherein
a buffer portion extending in a curved shape is provided between the first body portion (11) and the stacking portion (13); and/or
the buffer portion extending in a curved shape is provided between the second body portion (12) and the stacking portion (13).

10. The flexible circuit member (1) according to any one of claims 1-4, further comprising a support structure (5) disposed between adjacent layers in the stacking portion (13).

11. The flexible circuit member (1) according to claim 10, wherein the support structure (5) is a plate-shaped structure parallel to a layer structure of the stacking portion (13).

12. The flexible circuit member (1) according to claim 10, wherein the support structure (5) is a strip-shaped structure parallel to a layer structure of the stacking portion (13), and the strip-shaped structure is disposed in a folded bent zone of adjacent layers in the stacking portion (13).

13. A battery apparatus, comprising a battery group (9) and the flexible circuit member (1) according to any one of claims 1-12, wherein the flexible circuit member (1) spans over the battery group (9).

14. The battery apparatus according to claim 13, comprising at least two battery groups (9), wherein the flexible circuit member (1) spans over the at least two battery groups (9), and the stacking portion (13) of the flexible circuit member (1) is located in a gap between the adjacent battery groups (9).

15. The battery apparatus according to claim 13, wherein the battery apparatus is a battery module or a battery pack.

16. A preparation method of a flexible circuit member (1), the flexible circuit member (1) being configured to collect information of a battery unit in a battery apparatus, and the preparation method comprising the following steps:
providing an integrally-formed flexible circuit board (10), wherein the flexible circuit board (10) comprises an extensible unit, and the extensible unit comprises a first body portion (11), a second body portion (12), and a connection portion (14) connected between the first body portion (11) and the second body portion (12); and
performing folding processing on the extensible unit to form an extension unit, wherein the connection portion (14) forms a stacking portion (13) having at least two layers due to the folding processing, the extension unit comprises the first body portion (11), the second body portion (12), and the stacking portion (13) connected between the first body portion (11) and the second body portion (12), a first end of the extension unit in a long-axis direction (X) is an end portion of the first body portion (11) that is not connected to the stacking portion (13) in the long-axis direction (X), and a second end of the extension unit in the long-axis direction (X) is an end portion of the second body portion (12) that is not connected to the stacking portion (13) in the long-axis direction (X), a conductive wire harness in the extension unit for electrical signal transmission extends from the first end to the second end, and a distance between the first end and the second end of the extension unit in the long-axis direction (X) increases due to the folding processing.

17. The preparation method of the flexible circuit member (1) according to claim 16, wherein the step of providing the integrally-formed flexible circuit board (10) comprises the following step:
cutting a piece of flexible circuit board material to obtain at least one integrally-formed flexible circuit board (10).

18. The preparation method of the flexible circuit member (1) according to claim 17, wherein the step of cutting the piece of flexible circuit board material comprises the following steps:
cutting a square flexible circuit board material in a direction parallel to a longer side of the square flexible circuit board material to form a cutting slit (2); and forming the first body portion (11) and the second body portion (12) on two sides of the cutting slit (2), wherein a first end of the cutting slit (2) is a cut, and a second end of the cutting slit (2) is adjacent to the connection portion (14).

19. The preparation method of the flexible circuit member (1) according to claim 17, wherein the step of cutting the piece of flexible circuit board material comprises the following steps:
cutting a strip-shaped groove (4) on a square flexible circuit board material, wherein an extending direction of the strip-shaped groove (4) is parallel to a longer side direction of the square flexible circuit board material; and forming the first body portion (11) and the second body portion (12) on two sides of the strip-shaped groove (4), wherein a first end of the strip-shaped groove (4) is a notch and a second end of the strip-shaped groove (4) is adjacent to the connection portion (14).

## Amended claims

### Amended claims in accordance with Rule 137(2) EPC.

1. A flexible circuit member (1), configured to be disposed in a battery apparatus to collect information of a battery unit in the battery apparatus, the flexible circuit member (1) being formed by performing folding processing on an integrally-formed flexible circuit board (10), and the flexible circuit member (1) comprising an extension unit, wherein the extension unit includes a first body portion (11), a second body portion (12), and a stacking portion (13) connected between the first body portion (11) and the second body portion (12),
the stacking portion (13) has at least two layers due to the folding processing,
a first end of the extension unit in a long-axis direction (X) is an end portion of the first body portion (11) that is not connected to the stacking portion (13) in the long-axis direction (X), and a second end of the extension unit in the long-axis direction (X) is an end portion of the second body portion (12) that is not connected to the stacking portion (13) in the long-axis direction (X),
a conductive wire harness in the extension unit for electrical signal transmission extends from the first end to the second end,
a distance between the first end and the second end in the long-axis direction (X) decreases after the stacking portion (13) is unfolded
a buffer portion (15) extending in a curved shape is provided between the first body portion (11) and the stacking portion (13); and/or the buffer portion (15) extending in a curved shape is provided between the second body portion (12) and the stacking portion (13).

2. The flexible circuit member (1) according to claim 1, wherein a cutting slit (2) is provided between the first body portion (11) and the second body portion (12) after the stacking portion (13) is unfolded, a first end of the cutting slit (2) is a cut, and a second end of the cutting slit (2) is adjacent to the unfolded stacking portion (13).

3. The flexible circuit member (1) according to claim 2, wherein the second end of the cutting slit (2) is provided with an anti-tearing opening (3).

4. The flexible circuit member (1) according to claim 1, wherein after the stacking portion (13) is unfolded, a strip-shaped groove (4) is provided between the first body portion (11) and the second body portion (12), and a first end of the strip-shaped groove (4) is a notch and a second end of the strip-shaped groove (4) is adjacent to the unfolded stacking portion (13).

5. The flexible circuit member (1) according to any one of claims 1-4, comprising at least two extension units, wherein any adjacent two extension units share one first body portion (11) or one second body portion (12), and two ends of the shared first body portion (11) or the shared second body portion (12) are respectively connected to the stacking portions of the adjacent two extension units in the long-axis direction (X).

6. The flexible circuit member (1) according to any one of claims 1-4, wherein a folding line is provided between adjacent layers in the stacking portion (13), and the stacking portion (13) at least has the folding line perpendicular to the long-axis direction (X).

7. The flexible circuit member (1) according to any one of claims 1-4, wherein the first body portion (11) and the second body portion (12) are strip-shaped, and an extending direction of the first body portion (11) and an extending direction of the second body portion (12) are parallel to the long-axis direction (X).

8. The flexible circuit member (1) according to claim 7, wherein the extending direction of the first body portion (11) and the extending direction of the second body portion (12) are located on a straight line.

9. The flexible circuit member (1) according to any one of claims 1-4, further comprising a support structure (5) disposed between adjacent layers in the stacking portion (13).

10. The flexible circuit member (1) according to claim 9, wherein the support structure (5) is a plate-shaped structure parallel to a layer structure of the stacking portion (13).

11. The flexible circuit member (1) according to claim 9, wherein the support structure (5) is a strip-shaped structure parallel to a layer structure of the stacking portion (13), and the strip-shaped structure is disposed in a folded bent zone of adjacent layers in the stacking portion (13).

12. A battery apparatus, comprising a battery group (9) and the flexible circuit member (1) according to any one of claims 1-11, wherein the flexible circuit member (1) spans over the battery group (9).

13. The battery apparatus according to claim 12, comprising at least two battery groups (9), wherein the flexible circuit member (1) spans over the at least two battery groups (9), and the stacking portion (13) of the flexible circuit member (1) is located in a gap between the adjacent battery groups (9).

14. The battery apparatus according to claim 12, wherein the battery apparatus is a battery module or a battery pack.

15. A preparation method of a flexible circuit member (1), the flexible circuit member (1) being configured to be disposed in a battery apparatus to collect information of a battery unit in the battery apparatus, and the preparation method comprising the following steps:
providing an integrally-formed flexible circuit board (10), wherein the flexible circuit board (10) comprises an extensible unit, and the extensible unit comprises a first body portion (11), a second body portion (12), and a connection portion (14) connected between the first body portion (11) and the second body portion (12); and
performing folding processing on the extensible unit to form an extension unit, wherein the connection portion (14) forms a stacking portion (13) having at least two layers due to the folding processing, the extension unit comprises the first body portion (11), the second body portion (12), and the stacking portion (13) connected between the first body portion (11) and the second body portion (12), a first end of the extension unit in a long-axis direction (X) is an end portion of the first body portion (11) that is not connected to the stacking portion (13) in the long-axis direction (X), and a second end of the extension unit in the long-axis direction (X) is an end portion of the second body portion (12) that is not connected to the stacking portion (13) in the long-axis direction (X), a conductive wire harness in the extension unit for electrical signal transmission extends from the first end to the second end, and a distance between the first end and the second end of the extension unit in the long-axis direction (X) increases due to the folding processing, a buffer portion (15) extending in a curved shape is provided between the first body portion (11) and the stacking portion (13); and/or the buffer portion (15) extending in a curved shape is provided between the second body portion (12) and the stacking portion (13).

16. The preparation method of the flexible circuit member (1) according to claim 15, wherein the step of providing the integrally-formed flexible circuit board (10) comprises the following step:
cutting a piece of flexible circuit board material to obtain at least one integrally-formed flexible circuit board (10).

17. The preparation method of the flexible circuit member (1) according to claim 16, wherein the step of cutting the piece of flexible circuit board material comprises the following steps:
cutting a square flexible circuit board material in a direction parallel to a longer side of the square flexible circuit board material to form a cutting slit (2); and forming the first body portion (11) and the second body portion (12) on two sides of the cutting slit (2), wherein a first end of the cutting slit (2) is a cut, and a second end of the cutting slit (2) is adjacent to the connection portion (14).

18. The preparation method of the flexible circuit member (1) according to claim 16, wherein the step of cutting the piece of flexible circuit board material comprises the following steps:
cutting a strip-shaped groove (4) on a square flexible circuit board material, wherein an extending direction of the strip-shaped groove (4) is parallel to a longer side direction of the square flexible circuit board material; and forming the first body portion (11) and the second body portion (12) on two sides of the strip-shaped groove (4), wherein a first end of the strip-shaped groove (4) is a notch and a second end of the strip-shaped groove (4) is adjacent to the connection portion (14).
